# EUROPEAN PATENT APPLICATION

(11) **EP 3 589 093 A1**
(43) Date of publication of application: **01.01.2020**
(21) Application number: 18756912.4
(22) Date of filing: 20.02.2018
(51) Int. Cl.: H05K 3/46, B32B 15/082, C09J 7/20, C09J 11/04, C09J 11/06, C09J 201/00, H01L 23/12

(54) **MULTI-LAYER WIRING SUBSTRATE AND SEMICONDUCTOR DEVICE**

(30) Priority: 22.02.2017 JP 2017031408
(71) Applicant: Namics Corporation, Niigata-shi, Niigata 950-3131 (JP)
(72) Inventor: YOSHIDA, Masaki, Niigata-shi Niigata 950-3131 (JP); OHASHI, Satoko, Niigata-shi Niigata 950-3131 (JP)
(74) Representative: Zimmermann, Tankred Klaus
(86) International application number: PCT/JP2018/005932
(87) International publication number: WO 2018/155418

(57) **Abstract**

A purpose of the present disclosure is to provide a multilayer wiring substrate capable of reducing transmission loss of electrical signals when using a fluororesin substrate, by using an adhesive layer capable of suppressing misalignment between layers and having excellent peel strength. Provided is a multilayer wiring substrate 1 including: a fluororesin substrate 30 having a conductor pattern 20 formed on at least one surface thereof; and an adhesive layer 10 for bonding the fluororesin substrate 30, wherein the adhesive layer 10 contains a cured product of a thermosetting resin, and has a breaking elongation rate of 20% or more and 300% or less.

## Description

### TECHNICAL FIELD

The present disclosure relates to a multilayer wiring substrate and a semiconductor device.

### BACKGROUND ART

In recent years, with progress of miniaturization and high performance of electronic devices, there is a need for further speeding up of electrical signals used for information transmission. When transmitting high speed electrical signals, signal loss occurs. As the electrical signals get faster, the signal loss increases. As a technique of reducing the signal loss, a fluororesin substrate is generally used for circuit materials.

Further, with high functionality of parts, the circuit materials of a circuit substrate or the like, specifically, those of the multilayer wiring substrate suitable for high frequency circuits have been highly multilayered. Conventionally, in order to form a multilayer, a thermoplastic resin having a low dielectric constant and a low dielectric loss tangent (excellent in high frequency characteristics) is used as an adhesive layer.

As a multilayer fluororesin substrate, a copper-clad laminate including a copper foil bonded to a fluororesin insulating substrate is known. A feature of the copper-clad laminate is that the copper foil with smooth surfaces on both sides, which is neither roughened nor blackened, is bonded to the insulating substrate through a composite film of LCP and PFA (PATENT LITERATURE 1). A multilayer printed circuit substrate is also reported, which is formed of a plurality of laminated fluorocarbon resin-based base layers and includes at least one conductor layer therein (PATENT LITERATURE 2). A feature of the circuit substrate is that a base material layer including the above-mentioned inner conductor layer and a base material layer adjacent thereto are bonded to each other through the adhesive layer made of liquid crystal polymer.

However, in general, when the thermoplastic resin is used for the circuit substrate, there is a problem that misalignment occurs between layers when repeatedly heated to form the multilayer. It is possible to suppress misalignment by using a jig. However, minute misalignment cannot be prevented.

Specifically, the liquid crystal polymer (LCP) having a high melting point are used for both the copper-clad laminate and the multilayer printed circuit substrate described above. Therefore, phenomenon of misalignment between layers is aggravated. As a result, multilayering is more difficult.

### CITATION LIST

### PATENT LITERATURE

PATENT LITERATURE 1: JP-A-2007-098692
PATENT LITERATURE 2: JP-A-2005-268365

### SUMMARY OF THE INVENTION

### PROBLEMS TO BE SOLVED BY THE INVENTION

The inventors of the present invention have conducted intensive studies, to obtain the multilayer wiring substrate capable of reducing transmission loss of the electrical signals when using the fluororesin substrate by using the adhesive layer capable of suppressing misalignment between layers and having excellent peel strength.

An object of the present disclosure is to provide the multilayer wiring substrate capable of reducing the transmission loss of the electrical signals when using the fluororesin substrate by using the adhesive layer capable of suppressing misalignment between layers and having excellent peel strength, and the semiconductor device using the same.

### SOLUTION TO THE PROBLEMS

The present disclosure relates to the multilayer wiring substrate and the semiconductor device, which can solve the above problems by having the following configurations.
[1] A multilayer wiring substrate including: a fluororesin substrate having a conductor pattern formed on at least one surface thereof; and an adhesive layer for bonding the fluororesin substrate, wherein the adhesive layer contains a cured product of a thermosetting resin, and has a breaking elongation rate of 20% or more and 300% or less.
[2] The multilayer wiring substrate according to the above [1], wherein a tensile modulus of elasticity of the adhesive layer is 1GPa or less.
[3] The multilayer wiring substrate according to the above [1] or [2], wherein the adhesive layer includes a filler having a dielectric loss tangent of 0.002 or less.
[4] The multilayer wiring substrate according to any one of the above [1] to [3], wherein a dielectric constant of the adhesive layer is 70 to 130% when the dielectric constant of the fluororesin substrate is 100%.
[5] The multilayer wiring substrate according to any one of the above [1] to [4], wherein transmission loss on the adhesive layer is 0 to -3 dB/70 mm at 20 GHz.
[6] A semiconductor device including the multilayer wiring substrate according to any one of the above [1] to [5].

### EFFECTS OF THE INVENTION

According to the present disclosure [1], it is possible to provide a multilayer wiring substrate capable of reducing the transmission loss of the electrical signals when using a fluororesin substrate, by using an adhesive layer capable of suppressing misalignment between layers and having excellent peel strength.

According to the present disclosure [6], it is possible to provide a high reliability semiconductor component including the multilayer wiring substrate capable of reducing the transmission loss of the electrical signals by the adhesive layer capable of suppressing misalignment between layers and having excellent peel strength.

### BRIEF DESCRIPTION OF THE DRAWINGS

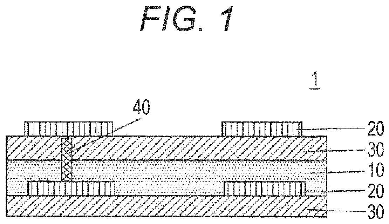

Fig. 1 is a schematic view showing an example of a cross-section of a multilayer wiring substrate.

### DESCRIPTION OF THE EMBODIMENTS

A multilayer wiring substrate of the present disclosure includes a fluororesin substrate having a conductor pattern formed on at least one surface thereof, and an adhesive layer for bonding the fluororesin substrate. The adhesive layer contains a cured product of a thermosetting resin, and has a breaking elongation rate of 20% or more and 300% or less. Fig. 1 is a schematic view showing an example of a cross-section of the multilayer wiring substrate. Fig. 1 shows an example of a cross-section of a two-layer wiring substrate. A multilayer wiring substrate 1 shown in Fig. 1 includes a fluororesin substrate 30 having a conductor pattern 20 formed on at least one surface thereof, and an adhesive layer 10 for bonding the fluororesin substrate 30. The adhesive layer 10 contains the cured product of the thermosetting resin. Further, the breaking elongation rate of the adhesive layer 10 is 20% or more and 300% or less.

As shown in Fig. 1, a via-hole (through-hole) 40 can be formed in the multilayer wiring substrate 1 as required.

### [Fluororesin substrate]

As the fluororesin substrate, for example, the fluororesin substrate described in JP-A-H07-323501 or JP-A-2005-268365 can be used. A specific example is a rigid substrate made of a prepreg, which is obtained by impregnating and holding polytetrafluoroethylene (PTFE) in a glass cloth. Another example is a so-called paper-making sheet obtained by forming by a wet paper-making method using fluororesin fibers and heat-resistant insulating fibers such as glass fiber.

Examples of fluororesins used for the fluororesin substrate include polytetrafluoroethylene (PTFE), copolymer of tetrafluoroethylene and perfluoroalkyl vinyl ether (PFA), copolymer of tetrafluoroethylene, hexafluoropropylene and perfluoroalkyl vinyl ether (FEPPFA), FEP, polychlorotrifluoroethylene (PCTFE), vinylidene fluoride resin (PVDF), vinyl fluoride resin (PVF), copolymer of ethylene and tetrafluoroethylene (ETFE), and copolymer of ethylene and chlorotrifluoroethylene (ECTFE). Among the fluororesins, PTFE is preferred from the viewpoint of low dielectric constant, low dielectric loss tangent, heat resistance, chemical resistance and the like. A melting point of PFA or the like is preferably 280°C or more. An example of molding temperature of the fluororesin is 320 to 400°C. The fluororesins may be used alone or in combination of two or more.

Examples of heat-resistant insulating fibers include inorganic fibers such as glass fibers, silica fibers, alumina fibers and aluminum silicate fibers, and organic fibers such as polyparaphenylene benzobisoxazole fibers (PBO fibers), aromatic polyester fibers, polyphenylene sulfide fibers and wholly aromatic polyamide fibers. The glass fibers are preferred from the viewpoint of heat resistance, high strength, high elastic modulus, and low cost. The heat-resistant insulating fibers may be used alone or in combination of two or more.

The conductor pattern includes copper wiring or the like which is formed by etching of copper foil.

### [Adhesive layer]

The adhesive layer contains the cured product of the thermosetting resin. The breaking elongation rate of the adhesive layer is 20% or more and 300% or less.

The thermosetting resin imparts adhesiveness and heat resistance (melting resistance at the time of heating) to the adhesive layer. The thermosetting resin is not particularly limited as long as it provides the adhesive layer with the breaking elongation rate of 20% or more and 300% or less after thermosetting. Examples of thermosetting resins include modified polyphenylene ether, bisphenol A epoxy resin, biphenyl epoxy resin, naphthalene epoxy resin, bismaleimide, special acrylate, modified polyimide and the like. The resin containing modified polyphenylene ether or modified polyimide is preferred from the viewpoint of the breaking elongation rate and the dielectric constant of the adhesive layer. Specifically, modified polyphenylene ether having an ethylenically unsaturated group (specifically, a styrene group) at its end (for example, one described in JP-A-2004-059644) is more preferred since it has high adhesiveness also for small polar fluororesins due to its small polarity. The epoxy resins are not preferred because they generally have low breaking elongation rate and high dielectric constant by themselves. The thermosetting resins may be used alone or in combination of two or more.

The epoxy resins as thermosetting resins may require a curing agent. The curing agent is not particularly limited. Examples of the curing agents are imidazole-based, amine-based, acid anhydride-based and phenol-based curing agents. The imidazole-based curing agents are preferred from the viewpoint of reaction temperature and reaction time. 1-benzyl-2-phenylimidazole and 2-phenyl-4,5-dihydroxymethylimidazole are more preferred.

The adhesive layer can also contain other resins. The other resins are added to improve the breaking elongation rate when the thermosetting resin alone cannot impart the breaking elongation rate of 20% or more to the adhesive layer after thermosetting. Examples of other resins include polystyrene-poly(ethylene/butylene) block copolymer, polystyrene-poly(ethylene-ethylene/propylene) block co-polymer, and the like, specifically as a styrene-based thermoplastic elastomer among polyolefin-based elastomers. These hydrogenated elastomers are preferred because they have low dielectric constants and low dielectric loss tangents. The other resins may be used alone or in combination of two or more.

The breaking elongation rate of the adhesive layer is preferably 20% or more and 300% or less from the viewpoint of peel strength with the copper foil. When the breaking elongation rate is less than 20%, the adhesive layer is hard and brittle. Therefore, the peel strength with copper foil is weak. When the breaking elongation rate exceeds 300%, misalignment is likely to occur during lamination. Here, the breaking elongation rate of the adhesive layer can be measured by an autograph.

The adhesive layer preferably contains a filler having a dielectric loss tangent of 0.002 or less from the viewpoint of further reducing transmission loss of the multilayer wiring substrate. Examples of the filler having the dielectric loss tangent of 0.002 or less include fluororesin fillers and silica fillers (including hollow silica particles). An average particle size of the filler having the dielectric loss tangent of 0.002 or less is preferably 0.01 to 10 µm, and more preferably 0.01 to 1 µm. Here, the average particle size can be measured by a laser diffraction particle size distribution measuring apparatus (model number: LS13320) produced by Beckman Coulter, Inc. The fillers having the dielectric loss tangent of 0.002 or less may be used alone or in combination of two or more.

Additives can be further added to the adhesive layer of the present embodiment as needed, as long as the purpose of the present embodiment is not impaired. Examples of the additives include leveling agents, antifoaming agents, thixotropic agents, antioxidants, pigments or dyes.

A tensile modulus of elasticity of the adhesive layer is preferably 1GPa or less from the viewpoint of internal stress relaxation of the multilayer wiring substrate which is a laminate and the peel strength between the fluororesin and the adhesive layer. Further, the tensile modulus of elasticity of the adhesive layer is preferably 0.1 GPa or more from the viewpoint of pressure resistance at the time of pressing. When the tensile modulus of elasticity is less than 0.1 GPa, the heat resistance (at the time of heat pressing or the like) of the adhesive layer is inferior, and misalignment is likely to occur.

When the dielectric constant of the fluororesin substrate is 100%, the dielectric constant of the adhesive layer is preferably 70 to 130%. The dielectric constant of the adhesive layer in this range is close to the dielectric constant of the fluororesin substrate. Therefore, design of the multilayer wiring substrate is simplified.

The transmission loss on the adhesive layer is preferably 0 to -3 dB/70 mm at 20 GHz from the viewpoint of efficient transmission and reception of electrical signals.

The adhesive layer can be preferably laminated even at a low temperature of 200°C or less from the viewpoint of low power (low energy) and reduction of thermal damage to members.

### [Multilayer wiring substrate]

As described above, the multilayer wiring substrate of the present disclosure includes the fluororesin substrate having the conductor pattern formed on at least one surface thereof, and the adhesive layer for bonding the fluororesin substrate. The adhesive layer contains the cured product of the thermosetting resin and has the breaking elongation rate of 20% or more and 300% or less. The multilayer wiring substrate is excellent in peel strength between the fluororesin substrate and the adhesive layer, and peel strength between the conductor pattern and the adhesive layer. It is considered that cause of this excellent peel strength is due to an anchor effect. It is considered that the breaking elongation rate of the adhesive layer contributes to the peel strength with the conductor (copper foil). When the breaking elongation rate is less than 20% or more than 300%, the peel strength with the copper foil is weak. Note that since the peel strength between the fluororesin substrate and the adhesive layer is high, peeling may occur between the fluororesin substrate and the copper foil, or the fluororesin substrate itself may be destroyed in a peel test.

### [Semiconductor device]

A semiconductor device of the present disclosure includes the above-described multilayer wiring substrate. Examples of the semiconductor device include a millimeter wave antenna and a wireless base station.

### Examples

The present embodiment will be described by way of examples. However, the present embodiment is not limited to the examples. In the following examples, parts and % respectively indicate parts by mass and % by mass unless otherwise specified.

As a thermosetting resin 1, modified polyphenylene ether (product name: OPE2St2200) produced by Mitsubishi Gas Chemical Company, Inc. was used.

As a thermosetting resin 2, modified polyphenylene ether (product name: OPE2St1200) produced by Mitsubishi Gas Chemical Company, Inc. was used.

As a thermosetting resin 3, bisphenol A epoxy resin (product name: LX-01) produced by Osaka Soda Co., Ltd. was used.

As a thermosetting resin 4, biphenyl epoxy resin (product name: NC3000) produced by Nippon Kayaku Co., Ltd. was used.

As a thermosetting resin 5, naphthalene epoxy resin (product name: HP4032D) produced by DIC Corporation was used.

As a thermosetting resin 6, bis-(3-ethyl-5-methyl-4-maleimidophenyl) methane (product name: BMI-70), which is bismaleimide produced by K·I Chemical Industry Co., Ltd., was used.

As a thermosetting resin 7, N-acryloyloxyethyl hexahydrophthalimide (trade name: M-140), which is a special acrylate produced by Toagosei Co., Ltd., was used.

As a curing agent 1, imidazole (product name: 1B2PZ) produced by Shikoku Chemicals Corporation was used.

As a curing agent 2, imidazole (product name: 2PHZ) produced by Shikoku Chemicals Corporation was used.

As another resin 1, elastomer SEBS (product name: G1652) produced by Kraton Corporation was used.

As another resin 2, elastomer SEBS (product name: G1657) produced by Kraton Corporation was used.

As another resin 3, elastomer SEEPS (product name: Septon 4044) produced by Kuraray Co., Ltd. was used.

As another resin 4, elastomer SEBS (trade name: Tuftec H1052) produced by Asahi Kasei Corporation was used.

As another resin 5, elastomer SBS (product name: TR2003) produced by JSR Corporation was used.

As a filler 1, fluororesin filler (trade name: Luburon L-2, average particle size: 2 µm) produced by Daikin Industries, Ltd. was used.

As a filler 2, silica filler (product name: SE2050, average particle size: 0.5 µm) produced by Admatechs Co., Ltd. was used.

Note that the dielectric loss tangent of the filler 1 and the dielectric loss tangent of the filler 2 were both 0.002 or less.

### [Examples 1 to 4 and Comparative Examples 1 to 4]

Components were measured and mixed in composition shown in Table 1. Thereafter, the components were charged into a reaction kettle heated to 80°C, and atmospheric pressure dissolution and mixing were performed for 3 hours while stirring at a rotational speed of 250 rpm. However, the curing agent was added after cooling. Although not shown in Table 1, toluene was used for dissolution and viscosity adjustment.

A varnish containing the composition for the adhesive layer thus obtained was applied to one side of a support (PET film subjected to release treatment). The varnish was dried at 100°C to obtain the film for the adhesive layer with the support (thickness of the adhesive layer: two types of about 25 µm and about 50 µm).

### [Measurement of breaking elongation rate of adhesive layer]

The film for the adhesive layer with the support was vacuum heat-pressed and cured under conditions of 200°C, 60 min and IMPa. The film for the adhesive layer with the support after curing was cut out to 15 mm×150 mm. After peeling off the support, it was pulled by the autograph at a pulling speed of 200 mm/min in its longitudinal direction, and a length stretched to breakage was measured. The breaking elongation rate of the adhesive layer is a value expressed as a percentage, which is obtained by dividing the length at break by the initial length. Table 1 shows measurement results of the breaking elongation rate of the adhesive layer.

### [Measurement of tensile modulus of elasticity of adhesive layer]

The film for the adhesive layer with the support was vacuum heat-pressed and cured under the conditions of 200°C, 60 min and 1MPa. A 25 mm×250 mm cured film with the support was cut out from the film for the adhesive layer with the support after curing. After peeling the support from the cured film with the support to obtain a test piece, a thickness of the test piece was measured. Next, the test piece was pulled in the longitudinal direction at a pulling speed of 1 mm/min using the autograph. Then, an inclination of stress-strain curve was measured when the test piece was stretched to 1 to 2 mm. This value was divided by a cross-sectional area to determine the tensile modulus of elasticity of the adhesive layer. The tensile modulus of elasticity of the adhesive layer is preferably 0.1 to 1GPa or less. Table 1 shows the measurement results of the tensile modulus of elasticity of the adhesive layer.

### [Measurement of peel strength]

The fluororesin substrate (product name: CGS-500) produced by Chukoh Chemical Industries, Ltd. was bonded on one side of the film for the adhesive layer peeled off from the support, and the copper foil (thickness: 35 µm, product name: CF-T8G-HTE) produced by Fukuda Metal Foil & Powder Co., Ltd. was bonded on the other side thereof, while being vacuum-heat pressed under the conditions of 200°C, 60 min and 2MPa. Thus, a laminated member was prepared. Thereafter, the copper foil or the fluororesin substrate was peeled off by the autograph, to measure the peel strength (90° peel) according to JIS K6854-1. The peel strength is preferably 7 N/cm or more. Table 1 shows the measurement results of the peel strength.

### [Evaluation of heat resistance]

The laminated member prepared by the same method as the above was floated in a solder bath at 260°C for 1 minute, and the presence or absence of peeling and swelling was visually checked.

### [Measurement of dielectric constant (ε), dielectric loss tangent (tan δ) of adhesive layer]

The film for the adhesive layer with the support was vacuum heat-pressed and cured under the conditions of 200°C, 60 min and 1MPa. The cured film (70 mm×130 mm) with the support was cut out from the film for the adhesive layer with the support after curing. After peeling the support from the cured film with the support to obtain the test piece, the thickness of the test piece was measured. Next, the dielectric constant (ε) and the dielectric loss tangent (tan δ) of the test piece were measured by SPDR method (1.9 GHz). The dielectric constant is preferably 1.6 to 3.5, and more preferably 2.0 to 2.9. The dielectric loss tangent is preferably 0.0005 to 0.005.

### [Calculation of a ratio of dielectric constants of fluororesin substrate and adhesive layer]

Next, a ratio (unit: %) of the dielectric constant of the adhesive layer when the dielectric constant of the fluororesin substrate was 100% was calculated. The dielectric constant of the fluororesin substrate used was 2.24. When the dielectric constant of the fluororesin substrate is 100%, the dielectric constant of the adhesive layer is preferably 70 to 130%.

### [Measurement of transmission loss of adhesive layer]

After removing the support, a 50 µm thick film for the adhesive layer before heat curing was sandwiched between two copper foils (produced by Fukuda Metal Foil & Powder Co., Ltd., 18 µm, CF-T9FZ-SV), and was then vacuum heat-pressed under the conditions of 200°C, 60 min and 1MPa. Thus, a copper-clad substrate was produced. On one surface of the copper-clad substrate, signal wiring having a signal wiring length of 70 mm and a ground pad were produced by etching so as to have an impedance of 50 Ω. The other surface of the copper-clad substrate was a ground layer. In order to connect the ground pad and the ground layer, a copper plating process was performed after the through-hole was formed. Thus, a 50 Ω microstrip line substrate was produced. At this time, a wiring height was about 30 µm by the copper plating process. The produced substrate was measured at 20 GHz using a network analyzer (manufactured by Keysight Technologies, Inc., N5245A). A measured value of the obtained S-parameter insertion loss (S21) was defined as the transmission loss on the adhesive layer. The transmission loss on the adhesive layer is preferably 0 to -3 dB/70 mm at 20 GHz.

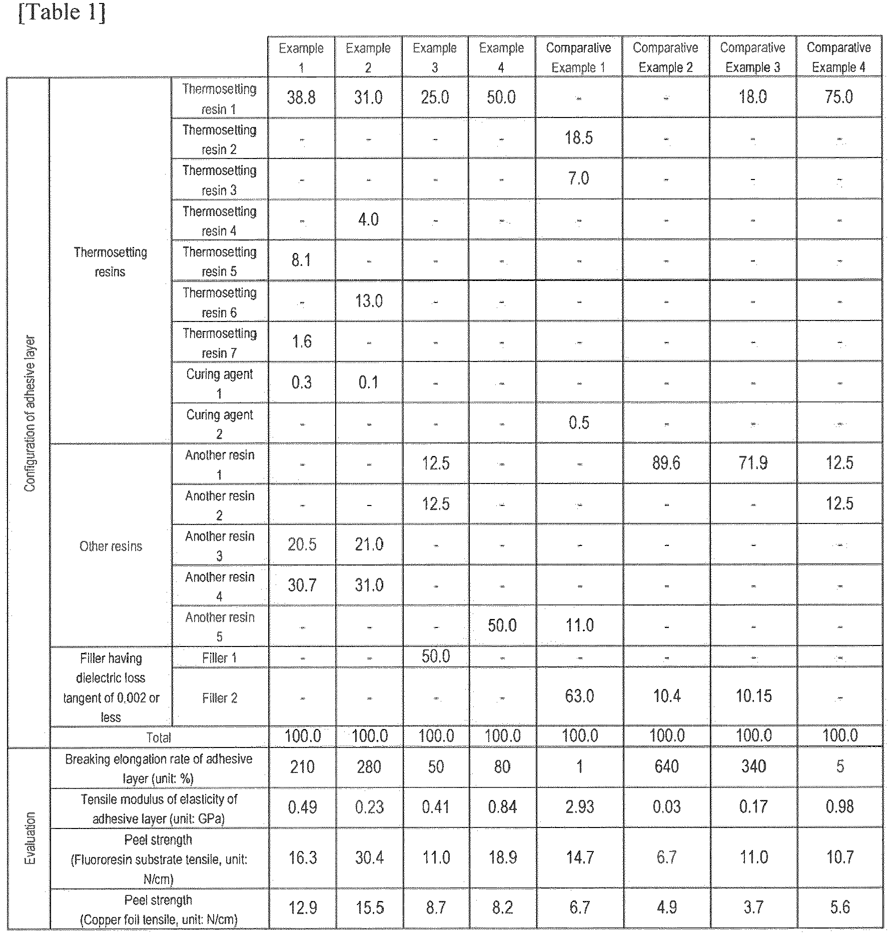

As can be seen from Table 1, in all of Examples 1 to 4 using a thermosetting resin which does not cause misalignment between layers, the breaking elongation rate of the adhesive layer was 50 to 280%, the tensile modulus of elasticity of the adhesive layer was 0.23 to 0.84GPa, and the peel strength was high. Although not shown in Table 1, in all of Examples 1 to 4, not only the heat resistance is good, but the dielectric constant of the adhesive layer was 2.4 to 2.5, the dielectric loss tangent of the adhesive layer was 0.0008 to 0.0025, the ratio of the dielectric constant of the fluororesin substrate and the dielectric constant of the adhesive layer was 107 to 112%, and all of them were good. The transmission loss of the adhesive layer was -2.2 dB in Example 1, -2.7 dB in Example 2, -2.1 dB in Example 3, and -2.3 dB in Example 4. In contrast, in Comparative Examples 1 and 4 in which the breaking elongation rate of the adhesive layer is too low, the peel strength with the copper foil was low. In Comparative Example 2 in which the breaking elongation rate of the adhesive layer is too high, the peel strength with the fluororesin substrate and the peel strength with the copper foil were both low. In Comparative Example 3 in which the breaking elongation rate of the adhesive layer is too high, the peel strength with the copper foil was low. Although not shown in Table 1, the transmission loss of the adhesive layer of Comparative Example 1 was -3.6 dB.

As described above, since the multilayer wiring substrate of the present disclosure uses the thermosetting resin for suppressing misalignment between layers, and uses the adhesive layer excellent in peel strength, the transmission loss of the electrical signals is low when using the fluororesin substrate. Therefore, the multilayer wiring substrate of the present disclosure is very useful.

### LIST OF REFERENCE NUMERALS

1: Multilayer wiring substrate, 10: Adhesive layer, 20: Conductor pattern, 30: Fluororesin substrate, 40: Via-hole (Through-hole).

## Claims

1. A multilayer wiring substrate comprising:
a fluororesin substrate having a conductor pattern formed on at least one surface thereof; and
an adhesive layer for bonding the fluororesin substrate, wherein
the adhesive layer contains a cured product of a thermosetting resin, and has a breaking elongation rate of 20% or more and 300% or less.

2. The multilayer wiring substrate according to claim 1, wherein a tensile modulus of elasticity of the adhesive layer is 1GPa or less.

3. The multilayer wiring substrate according to claim 1 or 2, wherein the adhesive layer includes a filler having a dielectric loss tangent of 0.002 or less.

4. The multilayer wiring substrate according to any one of claims 1 to 3, wherein a dielectric constant of the adhesive layer is 70 to 130% when the dielectric constant of the fluororesin substrate is 100%.

5. The multilayer wiring substrate according to any one of claims 1 to 4, wherein transmission loss on the adhesive layer is 0 to -3 dB/70 mm at 20 GHz.

6. A semiconductor device comprising the multilayer wiring substrate according to any one of claims 1 to 5.
